# EUROPÄISCHE PATENTSCHRIFT

(11) **EP 1 202 615 B1**
(45) Veröffentlichungstag und Bekanntmachung des Hinweises auf die Patenterteilung: **20.06.2007**
(21) Anmeldenummer: 01125262.4
(22) Anmeldetag: 24.10.2001
(51) Int. Cl.: H05K 1/02

(54) **Anordnung mit einem Substrat und einem damit verbundenen Verbindungselement**
Substate arrangment and element connected thereto
Arrangement sur un substrat et élément lui étant connecté

(30) Priorität: 24.10.2000 DE 10052713
(43) Veröffentlichungstag der Anmeldung: 02.05.2002
(73) Patentinhaber: SIEMENS AKTIENGESELLSCHAFT, 80333 München (DE)
(72) Erfinder: Allwang, Reinhard, 92421 Schwandorf (DE)

(56) Entgegenhaltungen:
- EP-A- 0 931 703
- DE-A- 19 851 455
- US-A- 5 166 867
- US-A- 5 624 269
- US-B1- 6 302 709
- PATENT ABSTRACTS OF JAPAN vol. 1998, no. 02, 30. Januar 1998 (1998-01-30) & JP 09 271113 A (TEMPEARL IND CO LTD), 14. Oktober 1997 (1997-10-14)

## Beschreibung

In Kraftfahrzeugen werden zunehmend mehr elektrische Verbraucher wie Fensterheber, Außenspiegel- und Scheibenheizungen etc. eingebaut, so dass bei der relativ geringen Versorgungsspannung des Generators ein hoher Strom erforderlich ist, um die benötigte Leistung bereitstellen zu können. Ein solch hoher Strom muss nicht nur über Substrate, insbesondere Leiterplatten, geführt werden können, er muss auch über geeignete Kontakt- und Verbindungselemente auf das Substrat gebracht und von dort wieder weggeführt werden können, ohne dass zu hohe Erwärmungen auftreten. Bisher wurden die Verbindungen zwischen einem Substrat und einem ein Kontaktelement aufweisenden als Stromschiene fungierenden Verbindungselement mittels Schraub- oder Einpresstechnik verwirklicht.

Die Aufgabe der Erfindung ist es, eine wirtschaftlich in Großserie fertigbare, hochstromfähige Verbindung zwischen einem Substrat und einem Kontaktelement aufzuzeigen. Außerdem soll eine zu starke Erwärmung der Verbindungsstelle und des Substrats verhindert werden.

Die Aufgabe wird durch einen Gegenstand gemäß Anspruch 1 gelöst. Vorteilhafte Weiterbildungen sind in den Unteransprüchen angegeben.

Demnach weist das als Stromschiene fungierende Verbindungselement neben dem Kontaktelement eine Anzahl von Lötanschlüssen auf, die kammartig angeordnet sind und auf einfache Weise mittels eines industriellen Lötverfahrens beispielsweise Wellenlöten elektrisch mit dem Substrat verbunden sind. Ein derartiges Verbindungselement is z.B aus der US-A-5 166 867 bekannt. Durch die Parallelschaltung mehrerer Lötanschlüsse verteilt sich der Strom, so dass keine der Lötstellen zu sehr erwärmt wird und zerstört werden kann.

Durch die Lötverbindung wird eine leistungsfähige thermische Anbindung des Verbindungselements an das Substrat erzielt, die kostengünstig herstellbar ist und dabei geometrisch frei gestaltet werden kann. Außerdem ist durch eine variable Anzahl von Lötanschlüssen eine Skalierbarkeit gegeben. Darüber hinaus ist die Verbindung platzsparend und kann zu Reparaturzwecken gelöst werden.

In Weiterbildung der Erfindung ist ein Kühlkörper über ein elektrisch isolierendes, gut wärmeleitendes Material mit dem Verbindungselement verbunden. Hierdurch wird eine aktive Kühlung der Anordnung erzielt.

Um die thermische Anbindung des Verbindungselements an den Kühlkörper zu verbessern, ist das Verbindungselement in Weiterbildung der Erfindung abgewinkelt und der abgewinkelte Teil mit dem Kühlkörper verbunden. Die hierdurch erzielte größere Verbindungsfläche ermöglicht einen besseren Wärmeübergang.

Die Erfindung wird nachfolgend anhand von Ausführungsbeispielen mit Hilfe von Figuren näher erläutert. Dabei zeigen:
Figur 1 eine erste Variante einer erfindungsgemäßen Anordnung und
Figur 2 eine zweite Variante einer erfindungsgemäßen Anordnung.

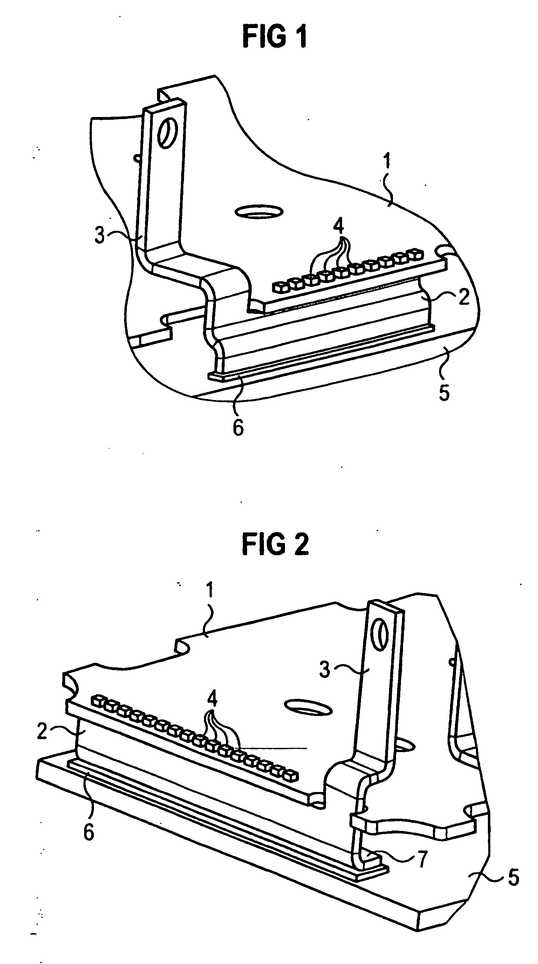

Gemäß Figur 1 ist ein Substrat 1, das insbesondere eine Leiterplatte sein kann mit einem Verbindungselement 2 versehen, das zur Kontaktierung des Substrats 1 über ein insbesondere einstückig mit dem Verbindungselement 2 verbundenes Kontaktelement 3 dient und auch als Stromschiene fungiert. Das Verbindungselement 2 weist eine Anzahl von Lötanschlüssen 4 auf, die durch nicht explizit dargestellte Löcher im Substrat 1 hindurchgeführt und mit dem Substrat verlötet sind, um eine elektrische Verbindung herzustellen.

Um eine Kühlung der Anordnung zu ermöglichen, ist das Verbindungselement 2 mit einem Kühlkörper 5 verbunden. Zur elektrischen Isolierung des Verbindungselements 2 und des Kühlkörpers 5 ist zwischen den beiden Teilen ein elektrisch isolierendes, jedoch trotzdem gut wärmeleitendes Material, das außerdem toleranzausgleichende Eigenschaften hat. Hierfür kommt beispielsweise eine "Gap Pad" genannte weiche, etwa 1 bis 5 mm dicke Folie oder "Gap Filler" genanntes beim Auftrag flüssiges Zweikomponentenmaterial, das anschließend aushärtet in Frage.

Um die Verbindungsfläche zwischen dem Verbindungselement 2 und dem Kühlkörper 5 zu vergrößern ist es von Vorteil, das Verbindungselement 2 gemäß Figur 2 abzuwinkeln und das abgewinkelte Teil 7 mit dem Kühlkörper 5 über ein wärmeleitendes Material 6 zu verbinden.

Durch die erfindungsgemäße Anordnung wird der Hochstrombereich für die industrielle Löttechnik im Automotive-Umfeld erschlossen.

## Patentansprüche

1. Vorrichtung mit einem Substrat (1) und einem eine einstückig ausgebildete, kammartige Anordnung einer Anzahl von Lötanschlüssen (4) aufweisenden, als Stromschiene fungierenden Verbindungselement(2), das mittels der Lötanschlüsse (4), die durch Löcher im Substrat (1) hindurchgeführt sind, elektrisch mit diesem verbunden ist,
**dadurch gekennzeichnet,**
**dass** mit der kammartigen Anordnung einer Anzahl von Lötanschlüssen (4) des Verbindungselements(2) ein hochstromfähiges Kontaktelement (39 einstückig verbunden ist.

2. Vorrichtung nach Anspruch 1, **dadurch gekennzeichnet, dass** das Verbindungselement (2) über ein elektrisch isolierendes, gut wärmeleitendes Material (6) mit einem Kühlkörper (5) verbunden ist.

3. Vorrichtung nach Anspruch 2, **dadurch gekennzeichnet, dass** das Verbindungselement (2) abgewinkelt ist und das abgewinkelte Teil (7) des Verbindungselements (2) über das elektrisch isolierende, gut wärmeleitende Material (6) mit dem Kühlkörper (5) verbunden ist.

## Claims

1. Device having a substrate (1) and a connecting element (2) functioning as a conductor rail, and comprising a comb-shaped arrangement, made in one-piece, of a number of solder connections (4), said connecting element (2) being electrically connected to the substrate (1) by means of the solder connections (4) which are guided through holes in said substrate (1),
**characterised in that**
a high-current capable contact element (39) is connected to the comb-shaped arrangement of a number of solder connections (4) of the connecting element (2) in one piece.

2. Device according to claim 1,
**characterised in that**
the connecting element (2) is connected to a cooling element (5) by way of an electrically insulating, good heat-conducting material (6).

3. Device according to claim 2,
**characterised in that**
the connecting element (2) is bent and the bent part (7) of the connecting element (2) is connected to the cooling element (5) by way of the electrically insulating, good heat-conducting material (6).

## Revendications

1. Dispositif comportant un substrat (1) et un élément de liaison 2 réalisé en une seule pièce, présentant une disposition en forme de peigne, d'un nombre de raccords par soudure (4), qui est relié électriquement au substrat (1) au moyen des raccords par soudure (4) qui traversent le substrat (1) par des trous,,
**caractérisé en ce qu'**un élément de contact (3) capable de laisser passer un courant élevé est relié en formant une seule pièce avec la disposition, en forme de peigne, d'un nombre de raccords par soudure (4) de l'élément de liaison.

2. Dispositif suivant la revendication 1, **caractérisé en ce que** l'élément de liaison (2) est relié à un corps de refroidissement (5) par un matériau isolant électrique et bon conducteur de la chaleur (6).

3. Dispositif suivant la revendication 1 ou 2, **caractérisé en ce que** l'élément de liaison (2) est coudé et **en ce que** la partie coudée (7) de l'élément de liaison (2) est reliée au corps de refroidissement (5) par le matériau isolant électrique, bon conducteur de la chaleur (6).
